# EUROPEAN PATENT APPLICATION

(11) **EP 4 580 067 A1**
(43) Date of publication of application: **02.07.2025**
(21) Application number: 23220746.4
(22) Date of filing: 29.12.2023
(51) Int. Cl.: H03M 13/11, H03M 13/00, H04L 1/00

(54) **APPARATUS AND METHOD OF SCHEDULING AND OPERATING PROCESSORS FOR DECODING FORWARD ERROR CORRECTION CODEWORDS**

(71) Applicant: Nokia Solutions and Networks Oy, 02610 Espoo (FI)
(72) Inventor: Giancarlo, Gavioli, 20865 Usmate Velate (IT); Razetti, Luca Gabriele, 20099 Sesto San Giovanni (IT); Costantini, Carlo, 23880 Lecco (IT); Cattaneo, Davide, 20831 Seregno (IT); Cucchi, Daniele, 20083 Milan (IT); Link, Thomas, 90451 Nuremberg (DE)
(74) Representative: DREISS Patentanwälte PartG mbB

(57) **Abstract**

An apparatus for and a method of operating processors (108) for decoding forward error correction, FEC, codewords, wherein the method comprises determining a rate of an increment in processors (108) that are active for decoding FEC codewords, and inhibiting (116) activation of a processor (108) for decoding FEC codewords when the rate of the increment is larger than a first threshold.

An apparatus for and a method of scheduling processors (108) for decoding forward error correction, FEC, codewords, wherein the method comprises receiving an indication (116) to inhibit activation of a processor (108) for decoding FEC codewords, and to inhibit activation of a processor (108) for decoding FEC codewords upon receiving the indication (116) to inhibit activation of a processor (108), or receiving an indication to inhibit deactivation of a processor (108) for decoding FEC codewords, and to inhibit deactivation of a processor (108) for decoding FEC codewords upon receiving the indication to inhibit deactivation of a processor (108).

## Description

### Field of the disclosure

Various examples relate to an apparatus and a method of scheduling and an apparatus and a method of operating processors for decoding forward error correction codewords.

### Background

In forward error correction, FEC, FEC codewords are decoded in a transceiver in iterations. FEC codewords are assigned to processors for decoding. A scheduler may operate a subset of the processors or all processors for decoding FEC codewords.

### Summary

A method of operating processors for decoding forward error correction, FEC, codewords, wherein the method comprises determining a rate of an increment in processors that are active for decoding FEC codewords, and inhibiting activation of a processor for decoding FEC packets when the rate of the increment is larger than a first threshold.

According to some examples, the method of operating processors comprises determining a rate of a decrement in processors that are active for decoding FEC codewords, and inhibiting to deactivate a processor for decoding FEC codewords when the rate of the decrement is larger than a second threshold.

According to some examples, the method of operating processors comprises sending an indication to inhibit deactivation of a processor for decoding FEC codewords when the rate of the decrement is larger than the second threshold.

According to some examples, the method of operating processors comprises sending an indication to inhibit activation of a processor for decoding FEC codewords when the rate of the increment is larger than the first threshold.

According to some examples, the method of operating processors comprises receiving a first input indicating a count of processors that are activated in a time slot, wherein the count of one indicates that one processor is activated in the time slot, wherein the count of zero indicates that no processor is activated in the time slot, and receiving a second input indicating a count of processors that are deactivated in the processing of FEC codewords in the time slot, wherein the count of one indicates that one processor is deactivated in the time slot, wherein the count of zero indicates that no processor is deactivated in the time slot, and determining the rate of increment or the rate of decrement depending on the first input and the second input.

According to some examples, the method of operating processors comprises determining the rate of increment or the rate of decrement depending on a difference between the first input and the second input wherein the difference of minus one indicates that no processor is activated and one processor is deactivated in the time slot, wherein the difference of plus one indicates that one processor is activated and no processor is deactivated in the time slot, wherein the difference of zero indicates that no processor is activated and no processor is deactivated in the time slot.

According to some examples, the method of operating processors comprises applying a low pass filter to the difference for determining the rate of increment or the rate of decrement.

A method of scheduling processors for decoding forward error correction, FEC, codewords, wherein the method comprises receiving an indication to inhibit activation of a processor for decoding FEC codewords, and to inhibit activation of a processor for decoding FEC codewords upon receiving the indication to inhibit activation of a processor, or receiving an indication to inhibit deactivation of a processor for decoding FEC codewords, and to inhibit deactivation of a processor for decoding FEC codewords upon receiving the indication to inhibit deactivation of a processor.

According to some examples, the method of scheduling processors comprises allocating a FEC codeword for decoding to a free processor, if a free processor is available, keeping a FEC codeword for decoding waiting in a memory buffer, or allocating a FEC codeword for decoding to a running processor.

According to some examples, the method of scheduling processors comprises sending a first output indicating a count of processors that are activated in the time slot, and sending a second output indicating a count of processors that are deactivated in the processing of FEC codewords in the time slot.

An apparatus for operating processors for decoding forward error correction, FEC, codewords, wherein the apparatus is configured for determining a rate of an increment in processors that are active for decoding FEC codewords, and inhibiting activation of a processor for decoding FEC codewords when the rate of the increment is larger than a first threshold.

According to some examples, the apparatus for operating processors is configured for determining a rate of a decrement in processors that are active for decoding FEC codewords, and inhibiting deactivation of a processor for decoding FEC codewords when the rate of the decrement is larger than a second threshold.

According to some examples, the apparatus for operating processors is configured for sending an indication to inhibit deactivation of a processor for decoding FEC codewords when the rate of the decrement is larger than the second threshold.

According to some examples, the apparatus for operating processors is configured for sending an indication to inhibit activation of a processor for decoding FEC codewords when the rate of the increment is larger than the first threshold.

According to some examples, the apparatus for operating processors is configured for receiving a first input indicating a count of processors that are activated in a time slot, wherein the count of one indicates that one processor is activated in the time slot, wherein the count of zero indicates that no processor is activated in the time slot, and receiving a second input indicating a count of processors that are deactivated in the processing of FEC codewords in the time slot, wherein the count of one indicates that one processor is deactivated in the time slot, wherein the count of zero indicates that no processor is deactivated in the time slot, and determining the rate of increment or the rate of decrement depending on the first input and the second input.

According to some examples, the apparatus for operating processors is configured for determining the rate of increment or the rate of decrement depending on a difference between the first input and the second input, wherein the difference of minus one indicates that no processor is activated and one processor is deactivated in the time slot, wherein the difference of plus one indicates that one processor is activated and no processor is deactivated in the time slot, wherein the difference of zero indicates that no processor is activated and no processor is deactivated in the time slot.

According to some examples, the apparatus for operating processors is configured for applying a low pass filter to the difference for determining the rate of increment or the rate of decrement.

An apparatus for scheduling processors for decoding forward error correction, FEC, codewords, wherein the apparatus is configured for receiving an indication to inhibit activation of a processor for decoding FEC codewords, and to inhibit activation of a processor for decoding FEC codewords upon receiving the indication to inhibit activation of a processor, or receiving an indication to inhibit deactivation of a processor for decoding FEC codewords, and to inhibit deactivation of a processor for decoding FEC codewords upon receiving the indication to inhibit deactivation of a processor.

According to some examples, the apparatus for scheduling processors is configured for allocating a FEC codeword for decoding to a free processor, if a free processor is available, keeping a FEC codeword for decoding waiting in a memory buffer, or allocating a FEC codeword for decoding to a running processor.

According to some examples, the apparatus for scheduling processors is configured for sending a first output indicating a count of processors that are activated in the time slot, and sending a second output indicating a count of processors that are deactivated in the processing of FEC codewords in the time slot.

A computer program comprising instructions, which, when executed by an apparatus, cause the apparatus to at least perform the method of operating processors or the method of scheduling processors.

### Brief description of the figures

Fig. 1 schematically depicts a first apparatus and a second apparatus according to a first example,

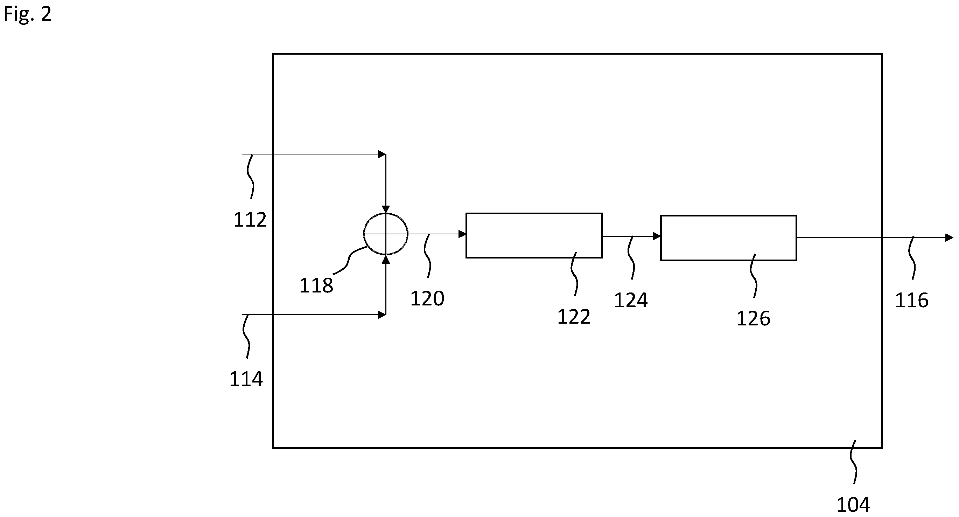

Fig. 2 schematically depicts the second apparatus according to the first example,
Fig. 3 depicts a sequence diagram according to the first example,

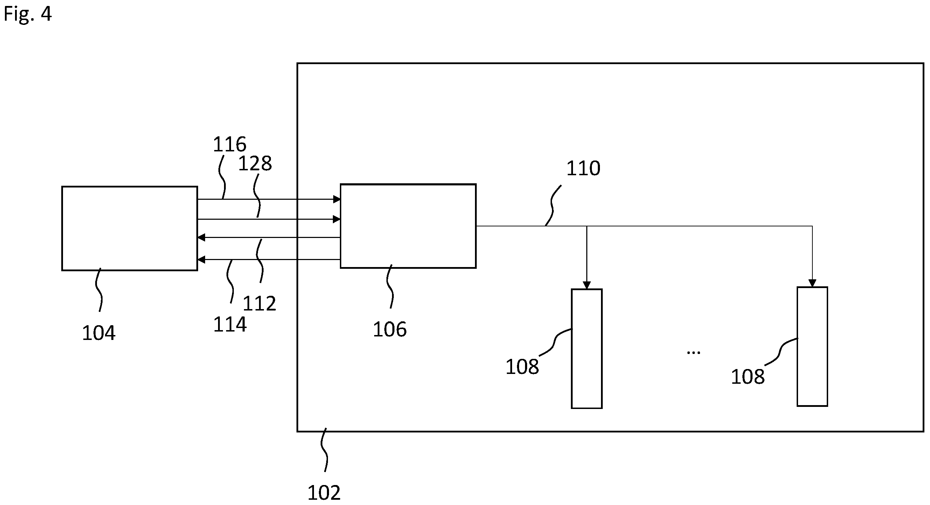

Fig. 4 schematically depicts a first apparatus and a second apparatus according to a second example,
Fig. 5 schematically depicts the second apparatus according to the second example,
Fig. 6 depicts a sequence diagram according to the second example.

### Description of the embodiments

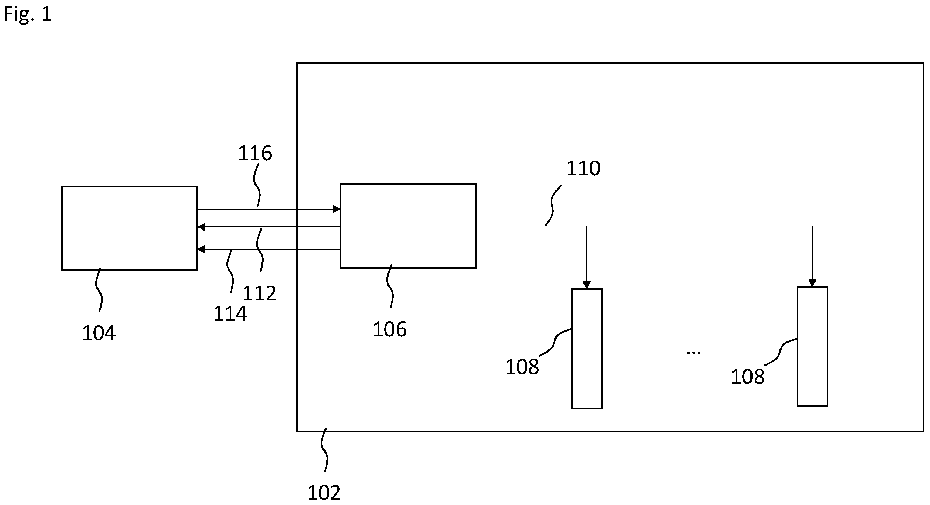

Figure 1 schematically depicts a first apparatus 102 and a second apparatus 104 according to a first example.

The first apparatus 102 may be part of a digital signal processing (DSP) chain of a coherent transceiver.

The first apparatus 102 is configured for decoding forward error correction, FEC, codewords.

According to an example, the first apparatus 102 is configured to decode FEC codewords of a Low-Density Parity-Check Code (LDPC) for the FEC.

The first apparatus 102 is configured to decode an input FEC codeword in iterations. An average number of iterations per input FEC codeword, depends on the FEC code design, the FEC coding gain and the working Signal to Noise Ratio (SNR)

The first apparatus 102 comprises a scheduler 106 and processors 108.

The processors 108 are configured for decoding the input FEC codeword.

The scheduler 106 is configured to schedule the processors 108 with a signal 110.

According to an example, the scheduler 106 is configured for operating a subset of the processors 108 or all processors 108 in a time slot for decoding the input FEC codeword, in a load-balancing configuration. According to an example, the scheduler 106 is configured for operating the subset of the processors 108 or all processors in parallel in the time slot.

The scheduler 106 may be configured for scheduling the processors 108 with a scheduling algorithm which allocates the processors 108 to FEC codewords as required to achieve a target Bit Error Rate, BER, minimizing both a number of active parallel processors 108 and the processing in each processor.

The scheduler 106 is configured for activating or for deactivating individual processors 108 via the signal 110. In this context, activating a processor 108 may refer to turning on the processor 108 or operating the processor 108 in a first power mode, wherein the processor 108 consumes a first amount of power. In this context, deactivating the processor 108 may refer to turning off the processor 108 or operating the processor 108 in a second power mode, wherein the processor 108 consumes a second amount of power. The second amount of power is less than the first amount of power.

The scheduling algorithm is based on the observation that in LDPC codes only a low number of iterations is typically necessary to decode most of the FEC codeword, while only very few require an exceptionally high number of iterations. By employing the processors 108 flexibly, the second apparatus 104 is capable of decoding with a variable number of iterations per FEC codeword. The scheduler 106 is configured for deactivating at least one processor 108 for FEC codewords that require a low number of iterations and for activating at least one processor 108 for FEC codewords that require a high number of iterations. This reduces the overall power consumption of the second apparatus 104.

According to the first example, the first apparatus 102 is configured for receiving an indication 116 to inhibit activation of a processor 108 for decoding FEC codewords, and to inhibit activation of a processor 108 for decoding FEC codewords upon receiving the indication 116 to inhibit activation of a processor 108.

According to an example, the indication 116 to inhibit activation of a processor 108 may be a value of one.

The first apparatus 102 may be configured for allocating a FEC codeword for decoding to a free processor 108 upon receiving the indication 116 to inhibit activation of a processor 108, if a free processor 108 is available.

The first apparatus 102 may be configured for keeping a FEC codeword for decoding waiting in a memory buffer upon receiving the indication 116 to inhibit activation of a processor 108.

The first apparatus 102 may be configured for allocating a FEC codeword for decoding to a running processor 108 upon receiving the indication 116 to inhibit activation of a processor 108.

The first apparatus 102 may be configured for sending a first output 112 indicating a count of processors 108 that are activated in the time slot.

The first apparatus 102 may be configured for sending a second output 114 indicating a count of processors 108 that are deactivated in the processing of FEC codewords in the time slot.

The second apparatus 104 is configured for operating the processors 108 for decoding FEC codewords.

The second apparatus 104 is configured for receiving a first input indicating a count of processors 108 that are activated in a time slot. The first input may be the first output 112 of the first apparatus 102.

According to an example, in the first input or the first output 112, the count of one indicates that one processor 108 is activated in the time slot.

According to an example, in the first input or the first output 112, the count of zero indicates that no processor is activated in the time slot.

The second apparatus 104 is configured for receiving a second input indicating a count of processors 108 that are activated in a time slot. The second input may be the second output 114 of the first apparatus 102.

According to an example, in the second input or the second output 112, the count of one indicates that one processor 108 is deactivated in the time slot.

According to an example, in the second input or the second output 112, the count of zero indicates that no processor is deactivated in the time slot.

The second apparatus 104 comprises a first comparator 118 that is configured for determining a difference 120 between the first input and the second input.

The difference 120 of minus one indicates that no processor is activated and one processor 108 is deactivated in the time slot.

The difference 120 of plus one indicates that one processor 108 is activated and no processor is deactivated in the time slot.

The difference 120 of zero indicates that no processor is activated and no processor is deactivated in the time slot.

The second apparatus 104 is configured for determining a rate of increment 124 or a rate of decrement 124 depending on the difference 120.

The second apparatus 104 is configured for applying a low pass filter 122 to the difference 120 for determining the rate of increment 124 or the rate of decrement 124.

The second apparatus 104 is configured for determining the rate of an increment 124 in processors 108 that are active for decoding FEC codewords.

The second apparatus 104 is configured for inhibiting activation of a processor 108 for decoding FEC codewords when the rate of the increment 124 is larger than a first threshold.

According to the first example, the second apparatus 104 may comprise a second comparator 126 that is configured for comparing the rate of the increment 124 to the first threshold and to output the indication 116 to inhibit activation of a processor 108 in case the rate of the increment 124 is larger than the first threshold, and otherwise not to output the indication 116 to inhibit activation of a processor 108.

According to an example, the second apparatus 104 may be configured for outputting the value of one as indication 116 to inhibit activation of a processor 108.

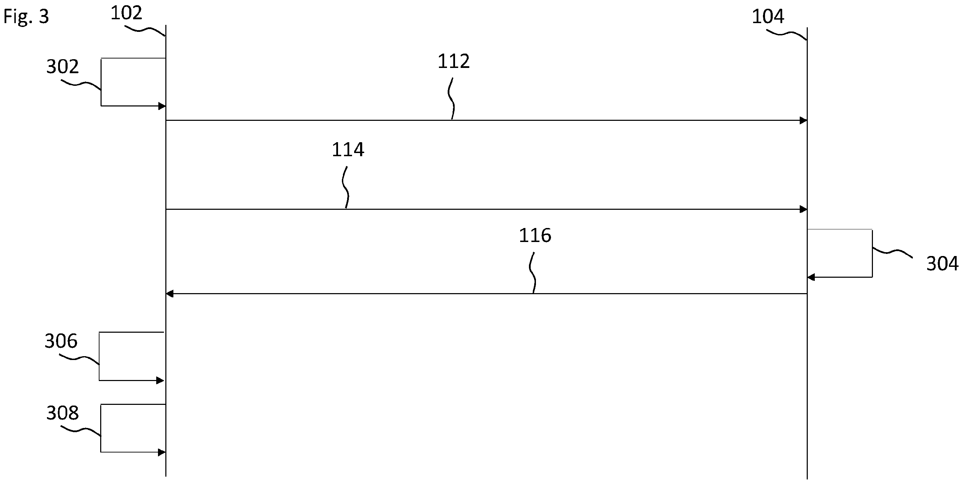

Figure 3 schematically depicts the first apparatus 102 and the second apparatus 104 according to a second example. The first apparatus 102 and the second apparatus 104 according to the second example are configured as described for the first example.

According to the second example, the first apparatus 102 is configured for receiving an indication 128 to inhibit deactivation of a processor 108 for decoding FEC codewords, and to inhibit deactivation of a processor 108 for decoding FEC codewords upon receiving the indication 128 to inhibit deactivation of a processor 108.

According to an example, the indication 128 to inhibit deactivation of a processor 108 may be a value of one.

According to the second example, the second apparatus 104 is configured for determining a rate of a decrement 124 in processors 108 that are active for decoding FEC codewords.

According to the second example, the second apparatus 104 is configured for inhibiting deactivation of a processor 108 for decoding FEC codewords when the rate of the decrement 124 is larger than a second threshold.

According to the second example, the second apparatus 104 may comprise a third comparator 130 that is configured for comparing the rate of the decrement 124 to the second threshold and to output the indication 128 to inhibit deactivation of a processor 108 in case the rate of the decrement 124 is larger than the second threshold, and otherwise not to output the indication 128 to inhibit deactivation of a processor 108.

According to an example, the second apparatus 104 may be configured for outputting the value of one as indication 128 to inhibit deactivation of a processor 108.

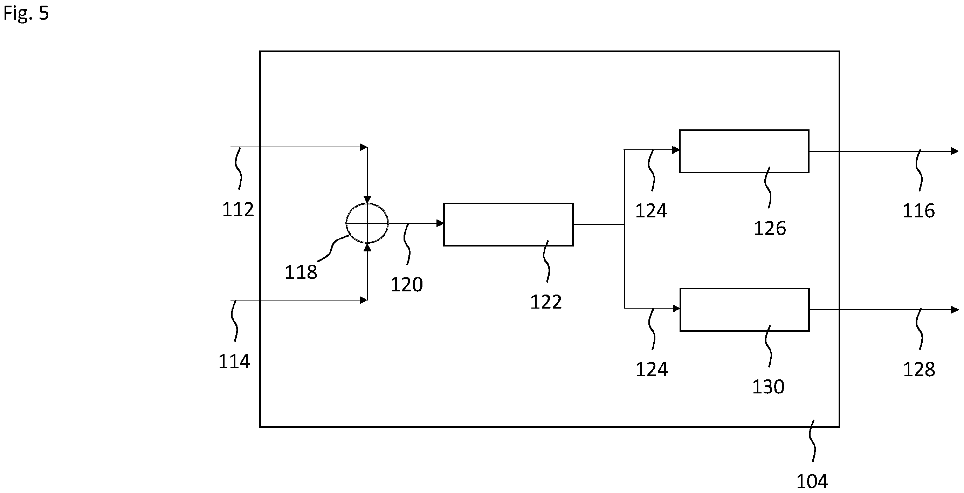

Figure 5 depicts a sequence diagram of a time slot. The sequence diagram comprises steps of a method in the first apparatus 102 of scheduling processors 108 for decoding FEC codewords and a method in the second apparatus 104 of operating the processors 108 for decoding FEC codewords according to the first example.

In a step 302, the first apparatus 102 activates or deactivates processors 108 of the first apparatus 102.

According to an example, the scheduling algorithm activates or deactivates processors 108.

The step 302 comprises determining the first output 112 and the second output 114.

The first output 112 is provided as first input to the second apparatus 104. The second output 114 is provided as second input to the second apparatus 104.

In a step 304, the second apparatus 104 determines the rate of the increment in processors 108 that are active for decoding FEC codewords.

The step 304 may comprise determining the rate of the decrement in processors 108 that are active for decoding FEC codewords.

According to an example, the step 304 comprises determining the rate of increment or the rate of decrement depending on the difference 120 between the first input and the second input.

According to an example, the step 304 comprises applying the low pass filter 122 to the difference 120 for determining the rate of increment 124 or the rate of decrement 124.

In the time slot, the activation of a processor 108 for decoding FEC codewords may be inhibited, when the rate of the increment is larger than the first threshold.

In the time slot, the deactivation of a processor 108 for decoding FEC codewords may be inhibited, when the rate of the decrement is larger than the second threshold.

The indication 116 to inhibit to activate a processor 108 for decoding FEC codewords is sent when the rate of the increment is larger than the first threshold.

The indication 128 to inhibit to deactivate a processor 108 for decoding FEC codewords is sent when the rate of the decrement is larger than the second threshold.

In a step 306, the activation of a processor 108 for decoding FEC codewords is inhibited upon receiving the indication 116 to inhibit activation of a processor 108.

In the step 306, the deactivation of a processor 108 for decoding FEC codewords is inhibited upon receiving the indication 128 to inhibit deactivation of a processor 108.

In a step 308, a FEC codeword for decoding is allocated to a free processor 108, if a free processor 108 is available.

In the step 308, a FEC codeword for decoding may be kept waiting in the memory buffer.

In the step 308, a FEC codeword for decoding may be allocated to a running processor 108.

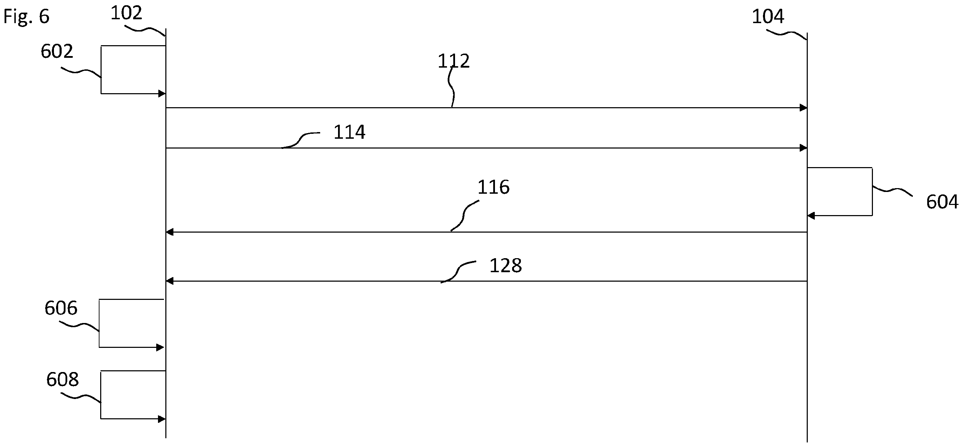

Figure 6 depicts a sequence diagram of a time slot. The sequence diagram comprises steps of a method in the first apparatus 102 of scheduling processors 108 for decoding FEC codewords and a method in the second apparatus 104 of operating the processors 108 for decoding FEC codewords according to the second example.

In a step 602, the first apparatus 102 activates or deactivates processors 108 of the first apparatus 102.

According to an example, the scheduling algorithm activates or deactivates processors 108.

The step 602 comprises determining the first output 112 and the second output 114.

The first output 112 is provided as first input to the second apparatus 104. The second output 114 is provided as second input to the second apparatus 104.

In a step 604, the second apparatus 104 determines the rate of the increment in processors 108 that are active for decoding FEC codewords.

The step 604 comprises determining the rate of the decrement in processors 108 that are active for decoding FEC codewords.

According to an example, the step 604 comprises determining the rate of increment or the rate of decrement depending on the difference 120 between the first input and the second input.

According to an example, the step 604 comprises applying the low pass filter 122 to the difference 120 for determining the rate of increment 124 or the rate of decrement 124.

In the time slot, the activation of a processor 108 for decoding FEC codewords may be inhibited, when the rate of the increment is larger than the first threshold.

In the time slot, the deactivation of a processor 108 for decoding FEC codewords may be inhibited, when the rate of the decrement is larger than the second threshold.

The indication 116 to inhibit activation of a processor 108 for decoding FEC codewords is sent when the rate of the increment is larger than the first threshold.

The indication 128 to inhibit deactivation of a processor 108 for decoding packets in the FEC is sent when the rate of the decrement is larger than the second threshold.

In a step 606, the activation of a processor 108 for decoding FEC codewords is inhibited upon receiving the indication 116 to inhibit activation of a processor 108.

In the step 606, the deactivation of a processor 108 for decoding FEC codewords is inhibited upon receiving the indication 128 to inhibit deactivation of a processor 108.

In a step 608, a FEC codeword for decoding is allocated to a free processor 108, if a free processor 108 is available.

In the step 608, a FEC codeword for decoding may be kept waiting in the memory buffer.

In the step 608, a FEC codeword for decoding may be allocated to a running processor 108.

## Claims

1. A method of operating processors (108) for decoding forward error correction, FEC, codewords, wherein the method comprises determining (304, 604) a rate of an increment in processors (108) that are active for decoding FEC codewords, and inhibiting (116) activation of a processor (108) for decoding FEC packets when the rate of the increment is larger than a first threshold.

2. The method according to claim 1, wherein the method comprises determining (604) a rate of a decrement in processors (108) that are active for decoding FEC codewords, and inhibiting (128) deactivation of a processor (108) for decoding FEC codewords when the rate of the decrement is larger than a second threshold.

3. The method according to claim 2, wherein the method comprises sending an indication (128) to inhibit deactivation of a processor (108) for decoding FEC codewords when the rate of the decrement is larger than the second threshold.

4. The method according to one of the preceding claims,
wherein the method comprises sending (116) an indication to inhibit activation of a processor (108) for decoding FEC codewords when the rate of the increment is larger than the first threshold.

5. The method according to one of the preceding claims,
wherein the method comprises receiving a first input (112) indicating a count of processors (108) that are activated in a time slot, wherein the count of one indicates that one processor (108) is activated in the time slot, wherein the count of zero indicates that no processor is activated in the time slot, and receiving a second input (114) indicating a count of processors that are deactivated in the processing of FEC codewords in the time slot, wherein the count of one indicates that one processor (108) is deactivated in the time slot, wherein the count of zero indicates that no processor is deactivated in the time slot, and determining (304, 604) the rate of increment or the rate of decrement depending on the first input and the second input.

6. The method according to claim 5, wherein the method comprises determining (304, 604) the rate of increment or the rate of decrement depending on a difference (120) between the first input (112) and the second input (114), wherein the difference (120) of minus one indicates that no processor is activated and one processor (108) is deactivated in the time slot, wherein the difference (120) of plus one indicates that one processor (108) is activated and no processor is deactivated in the time slot, wherein the difference (120) of zero indicates that no processor is activated and no processor is deactivated in the time slot.

7. The method according to claim 5 or 6, wherein the method comprises applying (304, 604) a low pass filter (122) to the difference (120) for determining the rate of increment (124) or the rate of decrement (124).

8. A method of scheduling processors (108) for decoding forward error correction, FEC, codewords, wherein the method comprises receiving an indication (116) to inhibit activation of a processor (108) for decoding FEC codewords, and to inhibit (306, 606) activation of a processor (108) for decoding FEC codewords upon receiving the indication (116) to inhibit activation of a processor (108), or receiving an indication (128) to inhibit deactivation of a processor (108) for decoding FEC codewords, and to inhibit (606) deactivation of a processor (108) for decoding FEC codewords upon receiving the indication (128) to inhibit deactivation of a processor (108).

9. The method according to claim 8, wherein the method comprises allocating (308, 608) a FEC codeword for decoding to a free processor, (108) if a free processor (108) is available, keeping (308, 608) a FEC codeword for decoding waiting in a memory buffer, or allocating (308, 608) a FEC codeword for decoding to a running processor (108).

10. The method according to one of the claims 8 or 9,
wherein the method comprises sending a first output (112) indicating a count of processors (108) that are activated in the time slot, and sending a second output (114) indicating a count of processors (108) that are deactivated in the processing of FEC codewords in the time slot.

11. An apparatus (104) for operating processors (108) for decoding forward error correction, FEC, codewords, wherein the apparatus (104) is configured for determining a rate of an increment (124) in processors (108) that are active for decoding FEC codewords, and inhibiting activation of a processor (108) for decoding FEC codewords when the rate of the increment (124) is larger than a first threshold.

12. The apparatus (104) according to claim 11, wherein the apparatus (104) is configured for determining a rate of a decrement (124) in processors (108) that are active for decoding FEC codewords, and inhibiting deactivation of a processor (108) for decoding FEC codewords when the rate of the decrement (124) is larger than a second threshold.

13. The apparatus (104) according to claim 12, wherein the apparatus (104) is configured for sending an indication (128) to inhibit deactivation of a processor (108) for decoding FEC codewords when the rate of the decrement (124) is larger than the second threshold.

14. The apparatus (104) according to one of the claims 11 or 12, wherein the apparatus (104) is configured for sending an indication (116) to inhibit activation of a processor (108) for decoding FEC codewords when the rate of the increment (124) is larger than the first threshold.

15. The apparatus (104) according to one of the claims 11 to 14, wherein the apparatus (104) is configured for receiving a first input (112) indicating a count of processors (108) that are activated in a time slot, wherein the count of one indicates that one processor (108) is activated in the time slot, wherein the count of zero indicates that no processor is activated in the time slot, and receiving a second input (114) indicating a count of processors (108) that are deactivated in the processing of FEC codewords in the time slot, wherein the count of one indicates that one processor (108) is deactivated in the time slot, wherein the count of zero indicates that no processor is deactivated in the time slot, and determining the rate of increment (124) or the rate of decrement (124) depending on the first input (112) and the second input (114).

16. The apparatus (104) according to claim 15, wherein the apparatus (104) is configured for determining the rate of increment (124) or the rate of decrement (124) depending on a difference (120) between the first input (112) and the second input (114), wherein the difference (120) of minus one indicates that no processor is activated and one processor (108) is deactivated in the time slot, wherein the difference (120) of plus one indicates that one processor (108) is activated and no processor is deactivated in the time slot, wherein the difference (120) of zero indicates that no processor is activated and no processor is deactivated in the time slot.

17. The apparatus (104) according to claim 15 or 16,
wherein the apparatus (104) is configured for applying a low pass filter (122) to the difference (120) for determining the rate of increment (124) or the rate of decrement (124)120104102.

18. An apparatus (102) for scheduling processors for decoding forward error correction, FEC, codewords, wherein the apparatus (102) is configured for receiving an indication (116) to inhibit activation of a processor (108) for decoding FEC codewords, and to inhibit activation of a processor (108) for decoding FEC codewords upon receiving the indication (116) to inhibit to activate a processor (108), or receiving an indication (128) to inhibit deactivation of a processor (108) for decoding FEC codewords, and to inhibit deactivation of a processor (108) for decoding packets upon receiving the indication (128) to inhibit deactivation of a processor (108).

19. The apparatus (102) according to claim 18, wherein the apparatus (102) is configured for allocating a FEC codewordfor decoding to a free processor (108), if a free processor (108) is available, keeping a FEC codeword for decoding waiting in a memory buffer, or allocating a FEC codeword for decoding to a running processor (108).

20. The apparatus (102) according to one of the claims 18 or 19, wherein the apparatus (102) is configured for sending a first output (112) indicating a count of processors (108) that are activated in the time slot, and sending a second output (114) indicating a count of processors (108) that are deactivated in the processing of FEC codewords in the time slot.

21. A computer program comprising instructions, which, when executed by an apparatus (104, 102) that is configured to execute the computer program, cause the apparatus (104, 102) to at least perform the method of operating processors (104) or the method of scheduling processors (108).
